# DEMANDE DE BREVET EUROPEEN

(11) **EP 4 687 294 A1**
(43) Date de publication de la demande: **04.02.2026**
(21) Numéro de dépôt: 25190198.9
(22) Date de dépôt: 17.07.2025
(51) Int. Cl.: H03K 17/13, H03K 17/725

(54) **COMMUTATEUR**

(30) Priorité: 30.07.2024 FR 2408444
(71) Demandeur: STMicroelectronics International N.V., 1228 Plan-les-Ouates, Geneva (CH)
(72) Inventeur: MOINDRON, Laurent, 37210 VERNOU SUR BRENNE (FR)
(74) Mandataire: Cabinet Beaumont

(57) **Abrégé**

La présente description concerne un dispositif de pilotage (Driv131, Driv132) d'un commutateur (130) comprenant :
- un premier circuit de pilotage (Driv131) dudit commutateur (130) référencé à une première borne (N110) adaptée à recevoir un potentiel alternatif, formé sur un premier substrat, et comportant une première diode dont l'anode est reliée audit premier substrat ;
- un deuxième circuit de pilotage (Driv132) référencé à une deuxième borne (GND100) adaptée à recevoir un potentiel de référence, formé sur un deuxième substrat, et comportant une deuxième diode dont l'anode est reliée audit deuxième substrat ; dans lequel la cathode de ladite première diode est reliée audit deuxième circuit de pilotage (Driv132), et la cathode de ladite deuxième diode est reliée audit premier circuit de pilotage (Driv131).

## Description

### Domaine technique

La présente description se rapporte de façon générale aux systèmes et dispositifs électroniques, et à l'alimentation de ces systèmes et dispositifs utilisant une tension alternative. La présente description concerne en particulier un commutateur adapté à commander l'alimentation d'une charge par une tension alternative.

### Technique antérieure

L'utilisation d'une tension alternative pour l'alimentation d'un dispositif électrotechnique ou électronique, appelé charge, est très commune. En effet, le réseau domestique fournit une tension alternative.

Il existe des commutateurs de commande adaptés à commander l'alimentation d'une charge par une tension alternative. Plus précisément, un tel commutateur est relié en série avec la charge et permet de la connecter ou de la déconnecter d'une alimentation fournissant une tension alternative.

Il serait souhaitable de pouvoir améliorer, au moins en partie, certains aspects des commutateurs de commande connus.

### Résumé de l'invention

Il existe un besoin pour des dispositifs et systèmes électroniques alimentés par une tension alternative de manière fiable.

Il existe un besoin pour des commutateurs adaptés à commander l'alimentation par des tensions alternatives de systèmes et dispositifs électroniques de manière fiable.

Il existe plus particulièrement un besoin pour des commutateurs bidirectionnels en tension et en courant permettant de commander l'alimentation d'un dispositif électronique par une tension alternative de manière fiable.

Un mode de réalisation pallie tout ou partie des inconvénients des dispositifs et systèmes électroniques connus alimentés par une tension alternative.

Un mode de réalisation pallie, en particulier, tout ou partie des inconvénients de commutateurs connus adaptés à commander l'alimentation par une tension alternative d'un système ou dispositif électronique.

Un mode de réalisation prévoit un commutateur bidirectionnel en tension et en courant.

Un mode de réalisation prévoit un commutateur bidirectionnel comprenant deux thyristors disposés en antiparallèle, chacun contrôlé par son propre circuit de pilotage.

Un mode de réalisation prévoit un dispositif électronique de pilotage d'un commutateur comprenant :
- une première borne adaptée à recevoir un potentiel alternatif ;
- une deuxième borne adaptée à recevoir un potentiel de référence ;
- un premier circuit de pilotage dudit commutateur référencé à ladite première borne, formé sur un premier substrat, et comportant une première diode dont la région d'anode est reliée audit premier substrat ;
- un deuxième circuit de pilotage dudit deuxième thyristor référencé à ladite deuxième borne formé sur un deuxième substrat différent du premier substrat, et comportant une deuxième diode dont la région d'anode est reliée audit deuxième substrat ;
dans lequel une région de cathode de ladite première diode est reliée audit deuxième circuit de pilotage, et une région de cathode de ladite deuxième diode est reliée audit premier circuit de pilotage.

Selon un mode de réalisation, ledit premier circuit de pilotage comprend un premier transistor de commande dudit commutateur, et ladite région de cathode de ladite deuxième diode est reliée à une borne de drain dudit premier transistor.

Selon un mode de réalisation, ledit deuxième circuit de pilotage comprend un deuxième transistor de commande dudit commutateur, et ladite région de cathode de ladite première diode est reliée à une borne de drain dudit deuxième transistor.

Selon un mode de réalisation, lesdits premier et deuxième transistors sont des transistors de type MOS.

Selon un mode de réalisation, lesdites première et deuxième diodes sont des diodes parasites de troisièmes transistors de type MOS.

Selon un mode de réalisation, lesdites première et deuxième diodes sont des diodes de substrat de troisièmes transistors.

Selon un mode de réalisation, lesdites première et deuxième diodes sont des diodes intrinsèque desdits troisièmes transistors dont les bornes de source sont reliées à leurs bornes de substrat.

Selon un mode de réalisation, lesdites première et deuxième diodes sont des diodes isolées latéralement par des tranchées d'isolation profonde.

Selon un mode de réalisation, ledit premier circuit de pilotage comprend un circuit d'alimentation relié à ladite première borne.

Un autre mode de réalisation prévoit un commutateur comprenant :
- un dispositif de pilotage décrit précédemment ;
- un premier thyristor dont la cathode est reliée à ladite première borne, et dont l'anode est reliée à ladite deuxième borne et adapté à être piloté par ledit premier circuit de pilotage ; et
- un deuxième thyristor dont l'anode est reliée à ladite première borne, et dont la cathode est reliée à ladite deuxième borne et adapté à être piloté par ledit deuxième circuit de pilotage.

Selon un mode de réalisation, ledit premier transistor comprend une borne de source reliée à la gâchette dudit premier thyristor.

Selon un mode de réalisation, ledit deuxième transistor comprend une borne de source reliée à la gâchette dudit deuxième thyristor.

Un autre mode de réalisation prévoit un dispositif électronique comprenant une charge adaptée à recevoir une tension alternative et un commutateur décrit précédemment, dans lequel une troisième borne de ladite charge est reliée à ladite première borne.

Un autre mode de réalisation prévoit un système électronique comprenant un dispositif décrit précédemment et une alimentation adaptée à fournir une tension alternative.

Un autre mode de réalisation prévoit un procédé de commande d'une charge alimentée par une alimentation adaptée à fournir une tension alternative, dans lequel ladite charge est reliée à ladite alimentation par un commutateur, ledit commutateur comprenant :
- une première borne adaptée à recevoir un potentiel alternatif ;
- une deuxième borne adaptée à recevoir un potentiel de référence ;
- un premier thyristor dont la cathode est reliée à ladite première borne, et dont l'anode est reliée à ladite deuxième borne ;
- un premier circuit de pilotage dudit commutateur référencé à ladite première borne, formé sur un premier substrat, et comportant une première diode dont la région d'anode est reliée audit premier substrat ;
- un deuxième circuit de pilotage dudit deuxième thyristor référencé à ladite deuxième borne formé sur un deuxième substrat différent du premier substrat, et comportant une deuxième diode dont la région d'anode est reliée audit deuxième substrat ;
dans lequel une région de cathode de ladite première diode est reliée audit deuxième circuit de pilotage, et une région de cathode de ladite deuxième diode est reliée audit premier circuit de pilotage.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un système électronique comprenant un commutateur selon un mode de réalisation ;
la figure 2 représente, plus en détails, un système électronique comprenant un commutateur selon un mode de réalisation ; et
la figure 3 représente une vue en coupe d'une partie d'un transistor de type MOS ; et
la figure 4 représente une vue en coupe d'une diode.

### Description des modes de réalisation

Des éléments similaires ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

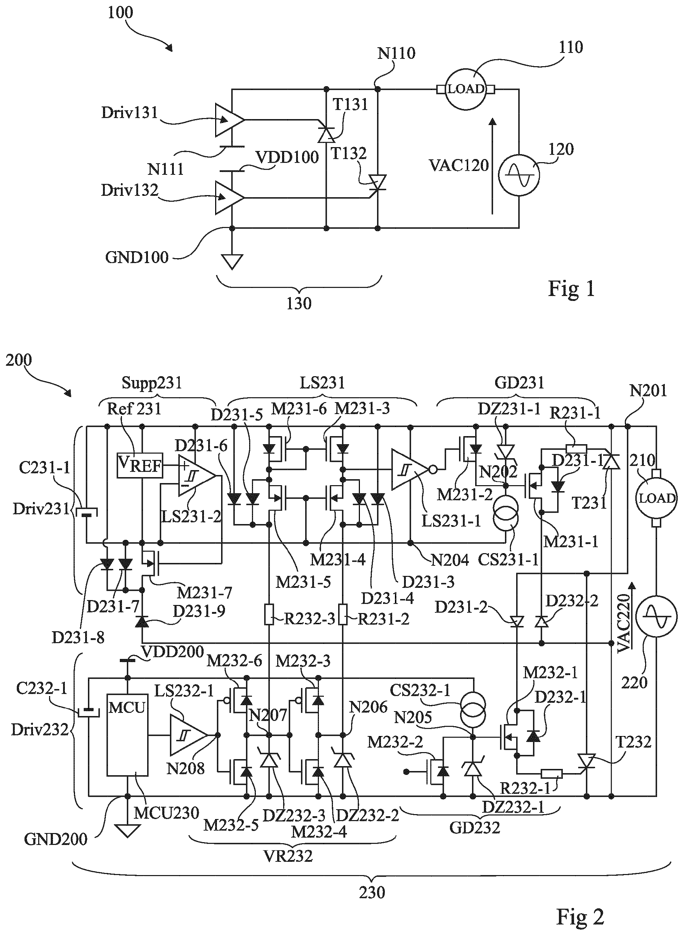

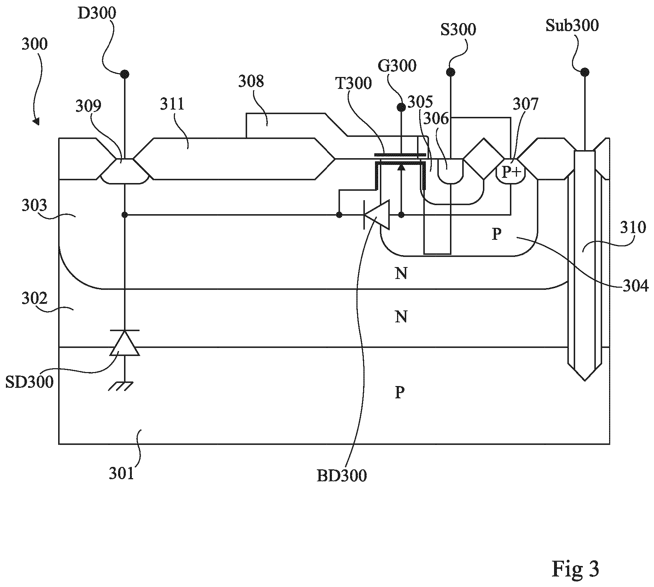

Les modes de réalisation décrits ci-après concernent l'alimentation par une tension alternative, comme une tension fournie par le réseau domestique, aussi appelé le secteur, de systèmes et dispositifs électroniques. Les modes de réalisation concernés par la présente description se rapportent plus particulièrement à un commutateur adapté à commander l'alimentation d'un dispositif électromécanique ou électronique. Le commutateur en question est un commutateur bidirectionnel en tension et en courant qui comprend deux thyristors disposés en antiparallèle et chacun commandés par son propre circuit de pilotage. Le schéma général d'un tel commutateur est décrit en relation avec la figure 1, et un exemple particulier de ce commutateur est décrit en relation avec la figure **2****.** Contrairement aux autres commutateurs du marché, ce commutateur présente l'avantage de ne pas présenter de problème de conduction incontrôlée au moment du changement de signe du courant alternatif. Pour cela, les circuits de pilotage adapté à piloter le commutateur utilisent des diodes disposées astucieusement pour se prémunir contre des polarités inverses. Cela est décrit en détail en relation avec les figures 2 et 3.

De plus, les modes de réalisation décrits ci-après sont tout particulièrement adaptés à être utilisés dans le domaine des dispositifs électroniques industriels comme les fours industriels (four de boulangerie, four destiné à des grandes cuissons), les moteurs industriels, en particulier leur circuits de démarrage qui peuvent appeler des courants à haute intensité, les relais statiques comme des interrupteurs adaptés aux hautes tensions, par exemple des tensions de l'ordre de 400 V et à hauts courants, par exemple des courants supérieurs à 1 A et pouvant aller jusqu'à quelques dizaines d'ampères.

De plus, de manière plus générale, les modes de réalisation décrits ci-dessus sont particulièrement adaptés pour être utilisés dans tout type de marchés industriels où une alimentation de dispositifs électroniques par des tensions alternatives est nécessaire. Plus particulièrement, un tel commutateur peut être destiné à l'industrie industrielle, par exemple dans le domaine de l'énergie verte, dans le domaine de l'électrification des infrastructures, de l'internet des objets (Internet of Things - IoT) et des maisons intelligentes (SmartHome), où la consommation d'électricité et d'énergie est un élément clé.

La figure 1 représente un mode de réalisation d'un système électronique 100.

Selon un mode de réalisation, le système électronique 100 comprend une charge 110 représentant la partie du système électronique 110 qui est destinée à être alimentée par une alimentation 120. Selon un exemple, la charge 110 est un dispositif électrotechnique. Le système 100 comprend, en outre, un mode de réalisation d'un commutateur 130 adapté à commander l'alimentation en courant et en tension de la charge 110 par l'alimentation 120.

Selon un mode de réalisation, l'alimentation 120 est une source de tension alternative adapté à fournir une tension VAC120 alternative permettant d'alimenter le dispositif électronique 110.

Pour former le système 100, ces différents éléments sont assemblés de la manière suivante. Une première borne de l'alimentation 120 est reliée, de préférence connectée, à une première borne de la charge 110. Une deuxième borne de l'alimentation 120 est reliée, de préférence connectée, à un noeud GND100 formant un noeud de référence du système 100 et fournissant un potentiel de référence, par exemple la masse. Une deuxième borne de la charge 110 est reliée, de préférence connectée, à un noeud N110. Une première borne du commutateur 130 est reliée, de préférence connectée, au noeud N110, et une deuxième borne du commutateur 130 est reliée, de préférence connectée, au noeud de référence GND100.

Selon un mode de réalisation, le commutateur 130 est un commutateur bidirectionnel en tension et en courant. Le commutateur 130 comprend deux thyristors T131 et T132 et leurs circuits de pilotage Driv131 et Driv132. Les thyristors T131 et T132 sont reliés en antiparallèle entre les noeuds N110 et GND100. Plus particulièrement, une borne de cathode du thyristor T131 est reliée, de préférence connectée, au noeud N110, et une borne d'anode du thyristor T131 est reliée, de préférence connectée, au noeud GND100. Une borne de cathode du thyristor T132 est reliée, de préférence connectée, au noeud GND100, et une borne d'anode du thyristor T132 est reliée, de préférence connectée, au noeud N110.

Le circuit de pilotage Driv131 est destiné à piloter le thyristor T131. Pour cela, le circuit de pilotage Driv131 comprend une borne de sortie reliée, de préférence connectée, à une borne de gâchette du thyristor T131. Le circuit de pilotage Driv131 est référencé par le noeud N110, et est alimenté par un potentiel fourni par un noeud N111.

Le circuit de pilotage Driv132 est destiné à piloter le thyristor T132. Pour cela, le circuit de pilotage Driv132 comprend une borne de sortie reliée, de préférence connectée, à une borne de gâchette du thyristor T132. Le circuit de pilotage Driv132 est alimenté par un noeud VDD100 fournissant une tension d'alimentation continue, et est référencé au noeud de référence GND100.

Selon un mode de réalisation, les circuits de pilotage Driv131 et Driv132 sont tous les deux intégrés sur deux puces différentes avec des substrats différents, chaque substrat étant référencés à un potentiel de référence différent. Plus particulièrement, le substrat du circuit de pilotage Driv131 est référencé au noeud N111 qui fournit un potentiel alternatif, et le substrat du circuit de pilotage Driv132 est référencé au noeud GND100. Selon un mode de réalisation, les deux puces dans lesquelles sont intégrés les circuits de pilotage Driv131 et Driv132 sont, ensuite, assemblées dans un seul boitier pour former un circuit unique qui peut être appelée dispositif de pilotage. Selon une variante, les deux puces des circuits de pilotage Driv131 et Driv132 ainsi que les deux puces des thyristors T131 et T132 peuvent être assemblés dans un unique boitier réalisant le commutateur 130.

Le système 100, et en particulier le commutateur 130 du dispositif 110, présente une amélioration lui permettant d'éviter des problèmes de conduction intempestive au moment du changement de signe du courant alternatif dans la charge 110. De tels problèmes sont connus chez certains commutateurs, tels que les triacs. Cette amélioration est décrite en détail en relation avec la figure 1.

Un procédé de commande de l'alimentation d'une charge au sein du système 100 est le suivant. Lorsque la charge 110 est en fonctionnement et a besoin d'être alimentée, le commutateur 130 est rendu conducteur. Pour cela, les circuits de pilotage Driv131 et Driv132 envoient une impulsion de courant de commande aux thyristors T131 et T132. Les thyristors T131 et T132 restent conducteurs tant qu'un courant les traversent. Lorsque la charge 110 n'est pas en fonctionnement et n'a pas besoin d'être alimentée, le commutateur 130 est rendu non passant. Pour cela, les thyristors T131 et T132 sont rendus non conducteurs en ne leur envoyant aucune impulsion de courant de commande.

Ainsi, les modes de réalisation décrits ici concernent un système du type du système 100, un commutateur du type du commutateur 130, et un dispositif de pilotage comprenant des circuits de pilotages du type des circuits de pilotages Driv131 et Driv132. Les modes de réalisation décrits ici concernent, en outre, un procédé de commande de l'alimentation d'une charge.

La figure 2 représente un mode de réalisation d'un système électronique 200 comprenant une charge 210 adaptée à être alimentée par une alimentation électrique 220 et dont l'alimentation est adaptée à être commandé par un mode de réalisation d'un commutateur 230.

Selon un mode de réalisation, la charge 210 est du type de la charge 110 décrite en relation avec la figure 1. De même, l'alimentation 220 est du type de l'alimentation 120 décrite en relation avec la figure 1, et fournit une tension d'alimentation alternative VAC220. Pour finir, le commutateur 230 est du type du commutateur 130 décrit en relation avec la figure 1.

Le commutateur 230 comprend une première borne reliée, de préférence connectée, à un noeud N201 qui est lui-même relié, de préférence connecté, à une borne de la charge 210. Le commutateur 230 comprend, en outre, une deuxième borne qui est reliée, de préférence connectée, à un noeud de référence GND200 du système 200.

Selon un mode de réalisation, comme le commutateur 130, le commutateur 230 est un commutateur bidirectionnel en tension et en courant. Le commutateur 230 comprend deux thyristors T231 et T232 et leurs circuits de pilotage Driv231 et Driv232. Les thyristors T231 et T232 sont reliés en antiparallèle entre les noeuds N201 et GND200. Plus particulièrement, une borne de cathode du thyristor T231 est reliée, de préférence connectée, au noeud N201, et une borne d'anode du thyristor T231 est reliée, de préférence connectée, au noeud GND200. Une borne de cathode du thyristor T232 est reliée, de préférence connectée, au noeud GND200, et une borne d'anode du thyristor T232 est reliée, de préférence connectée, au noeud N201.

Selon un mode de réalisation, les circuits de pilotage Driv231 et Driv232 sont tous les deux intégrés sur deux puces différentes avec des substrats différents, chaque substrat étant référencés à un potentiel de référence différent. Plus particulièrement, le substrat du circuit de pilotage Driv231 est référencé au noeud N201 qui fournit un potentiel alternatif, et le substrat du circuit de pilotage Driv132 est référencé au noeud GND200. Selon un mode de réalisation, les deux puces dans lesquelles sont intégrés les circuits de pilotage Driv231 et Driv232 sont, ensuite, assemblées dans un seul boitier pour former un circuit unique qui peut être appelée dispositif de pilotage. Selon une variante, les deux puces des circuits de pilotage Driv231 et Driv232 ainsi que les deux puces des thyristors T231 et T232 peuvent être assemblés dans un unique boitier réalisant le commutateur 230.

Le circuit de pilotage Driv231 est destiné à piloter le thyristor T231. Pour cela, le circuit de pilotage Driv231 comprend une borne de sortie reliée, de préférence connectée, à une borne de gâchette du thyristor T231. Le circuit de pilotage Driv231 est alimenté par le noeud N204, et est référencé à un noeud N201.

Le circuit de pilotage Driv231 comporte :
- un circuit GD231 de commande de la gâchette du thyristor T231 ;
- un circuit décaleur de niveau LS231 ; et
- un circuit d'alimentation Supp231.

Le circuit GD231 de commande de la gâchette du thyristor T231 est un circuit permettant de fournir une impulsion de courant de commande à la gâchette du thyristor T231. Autrement dit, une sortie du circuit GD231 correspond à la sortie du circuit de pilotage Driv231.

Le circuit GD231 comprend un transistor M231-1 à effet de champ à grille métal-oxyde (metal-oxide-semiconductor field-effect transistor), ou transistor MOSFET, ou transistor MOS. Selon un exemple, le transistor M231-1 est un transistor MOS à canal N, ou transistor MOS de type N, ou transistor NMOS. Selon une variante à la portée de la personne du métier, le transistor M231-1 peut être un transistor MOS à canal P, ou transistor MOS de type P, ou transistor PMOS. Une borne de source du transistor M2321-1 est reliée à la gâchette du thyristor T231, par exemple par l'intermédiaire d'une résistance R231-1. Une borne de drain du transistor M231-1 est reliée au noeud de référence GND200. Une diode parasite du transistors M231-1 est représentée en figure **2****.** Cette diode parasite est une diode intrinsèque D231-1, aussi appelée body diode, dont l'anode est reliée, de préférence connectée, à la borne de source du transistor M231-1 et dont la cathode est reliée, de préférence connectée, à la borne de drain du transistor M231-1. Selon un mode de réalisation, le circuit GD231 comprend, en outre, une diode D231-2 formée dans et sur le substrat sur lequel est formé le circuit Driv231. Selon un mode de réalisation, une borne d'anode de la diode D231-2 est reliée, de préférence connectée, au noeud N201, et une borne de cathode de la diode D231-2 est reliée, de préférence connectée, à une borne du circuit de pilotage Driv232, par exemple la borne de drain du transistor M232-1 décrit ci-après. Le rôle de la diode D231-2 est décrit plus en détail ci-après. Selon un mode de réalisation, la diode D231-2 a son caisson dopé de type P reliée, de préférence connecté, au substrat du circuit de pilotage Driv231.

Selon un premier mode de réalisation préféré, la diode D231-2 est une diode parasite d'un transistor MOS non représenté en figure 2, par exemple une diode intrinsèque, aussi appelée body diode, ou une diode de substrat. Un exemple de structure d'un transistor MOS et de ses diodes parasites est décrit en relation avec la figure 3.

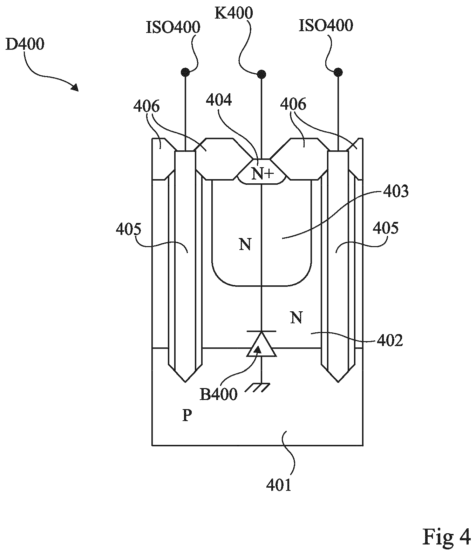

Selon un deuxième mode de réalisation, la diode D231-2 est une diode de substrat comme celle décrite en relation avec la figure 4.

Le circuit GD231 comprend, en outre, un deuxième transistor M231-2, une source de courant CS231-1 et une diode Zener DZ231-1. Le transistor M231-2 relie le noeud N201 à un noeud N202 qui est lui-même relié, de préférence connecté, à la borne de grille du transistor M231-1. Plus particulièrement, une borne de source du transistor M231-2 est reliée, de préférence connectée, au noeud N201, et une borne de drain du transistor M231-2 est reliée, de préférence connectée, au noeud N202. Une borne de grille du transistor M231-2 est adaptée à recevoir une tension de la part du circuit de décalage de niveau LS231. Une sortie de la source de courant CS231-1 est reliée, de préférence connectée, au noeud N202, et une borne de référence de la source de courant CS231-1 est reliée, de préférence connectée, à un noeud N204. L'anode de la diode Zener DZ231-1 est reliée, de préférence connectée, au noeud N201, et la cathode de la diode Zener DZ231-1 est reliée, de préférence connectée, au noeud N202.

Le circuit décaleur de niveau LS231 permet de décaler les signaux de commande du circuit Driv232 référencés au noeud GND200 et alimenté par le potentiel présent au niveau du noeud VDD200, vers le circuit Driv231 référencé au noeud N201 et alimenté par le circuit d'alimentation Supp231. Le circuit LS231 comprend un circuit décaleur de tension LS231-1 et quatre transistors NMOS M231-3, M231-4, M231-5 et M231-6.

Selon un exemple, le circuit décaleur de tension LS231-1 est alimenté par le potentiel du noeud N204, et est référencé au noeud N201. Une sortie inverseuse du circuit L231-1 est reliée, de préférence connectée, à la grille du transistor M231-3 du circuit GD231.

Selon un exemple, les transistors M231-3 et M231-6 sont des transistors basse tension, disposés de façon à former un circuit miroir de courant basse tension. Les transistors M231-4, M231-5 sont des transistors haute tension disposés de façon à former un montage cascode permettant de protéger le miroir de courant basse tension des hautes tensions. Plus particulièrement, une borne de source du transistor M231-3 est reliée, de préférence connectée, au noeud N201, et une borne de drain du transistor M231-3 est reliée, de préférence connectée à la borne de source du transistor M231-4. Une borne de drain du transistor M231-4 est reliée, de préférence connectée, aux bornes de grilles des transistors M231-4 et M231-5 et à la borne de drain du transistor M231-5. Une borne de source du transistor M231-6 est reliée, de préférence connectée, au noeud N201, et une borne de drain du transistor M231-6 est reliée, de préférence connectée, aux bornes de grille des transistors M231-3 et M231-6 et à la borne de source du transistor M231-5.

Les diodes intrinsèques des transistors M231-3, M231-**4,** M231-5 et M231-6 sont toutes représentées, et les diodes de substrat des transistors M231-4 et M231-5 sont également représentées. Plus particulièrement, le transistor M231-4 comprend une diode de substrat D231-3 et une diode intrinsèque D231-4. De même, le transistor M231-5 comprend une diode intrinsèque D231-5 et une diode intrinsèque D231-6.

Le circuit LS231 comprend, en outre, une résistance R231-2 reliant la borne de drain du transistor M231-4 au circuit de pilotage Driv232.

Le circuit d'alimentation Supp231 est adapté à fournir une tension d'alimentation à partir du potentiel fourni par le noeud N201. Pour cela, le circuit d'alimentation Supp231 comprend un circuit Ref231 fournissant un potentiel de référence, un circuit comparateur de tension à hystérésis LS231-2, un transistor M231-7 haute tension de type NMOS déplété et un condensateur d'alimentation C231-1. Une première borne du condensateur C231-1 est reliée, de préférence connectée, au noeud N204, et une deuxième borne du condensateur C231-1 est reliée, de préférence connectée, au noeud de référence N201. Le niveau de charge du condensateur C231-1 définie les phases de conduction et de non conduction du transistor M231-7. Le fonctionnement du circuit d'alimentation Supp231 est accessible à la personne du métier.

Le circuit Ref231 est alimenté par le potentiel du noeud N204 et est référencé au noeud N201, et fournit un potentiel de référence, par exemple un potentiel de référence différent du potentiel fournit par le noeud GND200. Le circuit Ref231 fournit ce potentiel de référence à une première entrée du circuit comparateur de tension à hystérésis LS231-2. Une deuxième entrée (-) du circuit comparateur de tension à hystérésis LS231-2 est reliée, de préférence connectée au noeud N204. Le circuit comparateur de tension à hystérésis est référencé au noeud N201, et commande la grille du transistor M231-7. Une borne de source du transistor M231-7 est reliée, de préférence connectée, au noeud N204, et une borne de drain du transistor M231-7 est reliée à l'anode du thyristor T231. Des diodes parasites du transistor M231-7 sont représentées en figure 2. Plus particulièrement, une diode intrinsèque D231-7 reliant les bornes de source et de drain du transistor M231-7 est représentée, et une diode de substrat D231-8 reliant la borne de drain au noeud N201 et au substrat du circuit DRIV231 est représentée. De plus, une autre diode parasite de substrat D231-9 apparaissant entre la borne de drain du transistor M231-7 et le noeud GND200, qui est lui-même connecté au substrat du circuit DRIV232.

Le circuit de pilotage Driv232 est destiné à piloter le thyristor T232. Pour cela, le circuit de pilotage Driv232 comprend une borne de sortie reliée, de préférence connectée, à une borne de gâchette du thyristor T232. Le circuit de pilotage Driv232 est alimenté par un noeud VDD100 fournissant une tension d'alimentation continue, et est référencé au noeud de référence GND100.

Le circuit de pilotage Driv232 comporte :
- un circuit GD232 de commande de la gâchette du thyristor T232 ;
- un circuit de commande VR232 du circuit décaleur de niveau LS231 ; et
- un circuit de commande MCU230.

Le circuit GD232 de commande de la gâchette du thyristor T232 est un circuit permettant de fournir une impulsion de courant de commande à la gâchette du thyristor T232. Autrement dit, une sortie du circuit GD232 correspond à la sortie du circuit de pilotage Driv232.

Le circuit GD232 comprend un transistor M232-1 de type NMOS. Selon une variante à la portée de la personne du métier, le transistor M232-1 peut être un transistor de type PMOS. Une borne de source du transistor M232-1 est reliée à la gâchette du thyristor T232, par exemple par l'intermédiaire d'une résistance R232-1. Une borne de drain du transistor M232-1 est reliée au noeud N201. Une diode parasite du transistor M232-1 est représentée en figure **2****.** Cette diode parasite est une diode intrinsèque D232-1, dont l'anode est reliée, de préférence connectée, à la borne de source du transistor M232-1 et dont la cathode est reliée, de préférence connectée, à la borne de drain du transistor M232-1. Selon un mode de réalisation, le circuit GD232 comprend, en outre, une diode D232-2 formée dans et sur le substrat sur lequel est formé le circuit Driv232. Selon un mode de réalisation, une borne de cathode de la diode D232-2 est reliée, de préférence connectée, à une borne du circuit de pilotage Driv231, plus particulièrement, à la borne de drain du transistor M231-1, et une borne d'anode de la diode D232-2 est reliée, de préférence connectée, au noeud GND200. Le rôle de la diode D232-2 est décrit plus en détail ci-après. Selon un mode de réalisation, la diode D232-2 a son caisson dopé de type P reliée, de préférence connecté, au substrat du circuit de pilotage Driv232.

Selon un premier mode de réalisation préféré, la diode D232-2 est une diode parasite d'un transistor MOS non représenté en figure 2, par exemple une diode intrinsèque, aussi appelée body diode, ou une diode de substrat. Un exemple de structure d'un transistor MOS et de ses diodes parasites est décrit en relation avec la figure 3.

Selon un deuxième mode de réalisation, la diode D232-2 est une diode de substrat comme celle décrite en relation avec la figure 4.

Le circuit GD232 comprend, en outre, un deuxième transistor M232-2, une source de courant CS232-1 et une diode Zener DZ232-1. Le transistor M232-2 relie le noeud GND200 à un noeud N205 qui est lui-même relié, de préférence connecté, à la borne de grille du transistor M232-1. Plus particulièrement, une borne de source du transistor M232-2 est reliée, de préférence connectée, au noeud GND200, et une borne de drain du transistor M232-2 est reliée, de préférence connectée, au noeud N205. Une borne de grille du transistor M232-2 est adaptée à recevoir le potentiel de commande du noeud N207. Une sortie de la source de courant CS232-1 est reliée, de préférence connectée, au noeud N205, et une borne d'alimentation de la source de courant CS232-1 est reliée, de préférence connectée, à un noeud VDD200 recevant un potentiel d'alimentation. L'anode de la diode Zener DZ232-1 est reliée, de préférence connectée, au noeud GND200, et la cathode de la diode Zener DZ232-1 est reliée, de préférence connectée, au noeud N205.

Le circuit de commande VR232 du circuit décaleur de niveau LS231, permet de générer deux signaux de commande complémentaires à partir du signal de commande fourni par le circuit de commande MCU230. Le circuit VR232 comprend deux inverseurs logiques de puissance formés par les transistors M232-5, M232-6, et les deux transistors M232-3 et M232-4, et un circuit bascule de Schmitt LS232-1, aussi connu sous le nom "Trigger de Schmitt" LS232-1, pour interpréter les signaux de commande fournis par le circuit de contrôle MCU230.

Selon un exemple, les transistors M232-3, M232-4, M232-5 et M232-6 sont disposés de façon à former deux inverseurs en cascade utilisés pour commander le circuit décaleur de niveau LS231. Plus particulièrement, une borne de source du transistor M232-3 est reliée, de préférence connectée, au noeud VDD200, et une borne de drain du transistor M232-3 est reliée, de préférence connectée à la borne de drain du transistor M232-4. Une borne de source du transistor M232-4 est reliée, de préférence connectée, au noeud de référence GND200. Une borne de source du transistor M232-6 est reliée, de préférence connectée, au noeud VDD200, et une borne de drain du transistor M232-6 est reliée, de préférence connectée à la borne de drain du transistor M232-5. Une borne de source du transistor M232-5 est reliée, de préférence connectée, au noeud de référence GND200. Les bornes de grille des transistors M232-3 et M232-4 sont reliées, de préférence connectées, entre elles et à un noeud N207. Ce noeud N207 est, en outre, relié, de préférence connecté, au noeud milieu entre les transistors M232-5 et M232-6. Les bornes de grille des transistors M232-5 et M232-6 sont reliées, de préférence connectées, entre elles et à une borne de sortie du circuit décaleur de tension LS232-1. Les diodes intrinsèques des transistors M232-3, M232-4, M232-5 et M232-6 sont toutes représentées.

Le circuit de commande VR232 comprend, en outre, des diodes Zener DZ232-2 et DZ232-3 destinées à protéger le circuit de pilotage Driv232 contre les décharges électrostatiques. Pour cela, une borne de cathode de la diode DZ232 est reliée, de préférence connectée, à un noeud N206 correspondant au noeud milieu entre les transistors M232-3 et M232-4. Ce noeud N206 est, en outre, reliée, de préférence connectée, à une deuxième borne de la résistance R232-1 du circuit LS231. Une borne d'anode de la diode DZ232-2 est reliée, de préférence connectée au noeud de référence GND200. Une borne de cathode de la diode DZ232-3 est reliée, de préférence connectée au noeud N207. Une borne d'anode de la diode DZ232-3 est reliée, de préférence connectée au noeud de référence GND200.

Une borne d'entrée du circuit décaleur de tension LS232-1 est reliée, de préférence connectée, à une sortie du circuit de commande MCU230.

Le circuit de commande VR232 comprend, en outre, une résistance R232-2 reliant le noeud N207 au circuit LS231 du circuit de pilotage Driv231. Plus particulièrement, une première borne de la résistance R232-2 est reliée, de préférence connectée, au noeud N207, et une deuxième borne de la résistance R232-2 est reliée, de préférence connectée, à la borne de drain du transistor M231-5.

Le circuit de commande MCU230 est adapté à fournir une tension de commande au transistor M232-1 qui la convertit en une impulsion de commande pour le thyristor T232. En pratique le circuit de commande MCU230 peut être un contrôleur, un microcontrôleur, un processeur et/ou un microprocesseur.

Le circuit de commande MCU230 peut comprendre, en outre, un condensateur d'alimentation C232-1. Une première borne du condensateur C232-1 est reliée, de préférence connectée, au noeud VDD200, et une deuxième borne du condensateur C232-1 est reliée, de préférence connectée, au noeud de référence GND200.

Un avantage des circuits de pilotage Driv231 et Driv232 est qu'il présente une plus forte résistance face aux polarisations inverses. En effet, les diodes D231-1 et D231-2 permettent de protéger les circuits de pilotages Driv231 et Driv232 contre les polarités inverses. Plus particulièrement, la diode D231-2, qui est formée dans et sur le substrat du circuit de pilotage Driv231, permet de protéger le circuit de pilotage Driv232, et en particulier son transistor M232-1, contre les polarités inverses. De même, la diode D232-2, qui est formée dans et sur le substrat du circuit de pilotage Driv232, permet de protéger le circuit de pilotage Driv231, et en particulier son transistor M231-1, contre les polarités inverses. Dit autrement, chaque circuit de pilotage Driv231, Driv232 est protégé contre les polarités inverses par une diode dont le caisson P est relié, de préférence connecté, au substrat de l'autre circuit de pilotage Driv232, Driv231. L'utilisation des diodes de substrat D231-2, D231-9 et D232-2 intégrées aux puces des circuits de pilotage Driv231 et Driv232 permet, en outre, d'éviter l'utilisation de diodes discrètes non intégrées.

Un procédé de commande de l'alimentation de la charge 210 au sein du système 200 est le suivant. Lorsque la charge 210 est en fonctionnement et a besoin d'être alimentée, le commutateur 230 est rendu conducteur. Pour cela, les circuits de pilotage Driv231 et Driv232 envoient une impulsion de courant de commande aux thyristors T231 et T232. Les thyristors T231 et T232 restent conducteurs tant qu'un courant les traversent. Lorsque la charge 210 n'est pas en fonctionnement et n'a besoin d'être alimentée, le commutateur 230 est rendu non passant. Pour cela, les thyristors T231 et T232 sont rendus non conducteurs en ne leur envoyant aucune impulsion de courant de commande.

La figure 3 est une vue en coupe illustrant un exemple pratique de réalisation d'un transistor T300 MOS à canal N, ou transistor NMOS et illustrant, en particulier, le positionnement de ses diodes parasites.

Comme dit précédemment, la figure 3 illustre un transistor T300 de type NMOS comprenant des diodes parasites, et en particulier une diode intrinsèque BD300 et une diode de substrat SD300. Comme tout transistor de type MOS, le transistor M300 comprend une borne de source S300, une borne de drain D300, une borne de grille G300 et une borne de substrat Sub300.

Le transistor T300 est formé dans et sur un substrat 301 dopée de type P. Un caisson dopé de type N, par exemple obtenu par un procédé d'épitaxie s'étend sur toute une portion supérieure du substrat 301. La jonction PN formée par le substrat 301 et le caisson 302 forme la diode de substrat SD300 du transistor T300. Plus particulièrement, la région d'anode de la diode SD300 est formée par le substrat 301, et la région de cathode de la diode SD300 est formée par le caisson 302.

Un caisson 303 dopé de type N, destiné à recevoir des hautes tensions, est formé dans le caisson 302. Ce caisson 303 permet de former la région de drain du transistor T300. Un caisson 304 dopé de type P est formé sur une portion du caisson 303 et s'étend sur une portion de la surface du caisson 303. Le caisson 304 permet de former la région de canal du transistor T300. La jonction PN formée par les caissons 303 et 304 forme la diode intrinsèque BD300 du transistor T300. Plus particulièrement, la région d'anode de la diode BD300 est formée par le substrat 304, et la région de cathode de la diode BD300 est formée par le caisson 303.

Un caisson 305 dopé de type N est formé dans le caisson 304. Ce caisson 305 permet de former la région de source du transistor T300. Une région de reprise de contact de source 306 dopée fortement de type N est formée dans le caisson 305. De même, une région de reprise de contact de source 307 dopée fortement de type P est formée dans le caisson 304.

Un empilement de grille 308 est formé sur la région de canal 304 et sur une portion de la région de drain 303 du transistor T300. Et un contact de grille est formé sur cet empilement 308. Une région de reprise de contact de drain 309 dopée fortement de type N est formée dans le caisson 304.

Toutes ces régions de reprises de contact sont délimitées par une couche 311 isolante électriquement. De plus, le transistor T300 peut être isolé latéralement par des tranchées isolantes électriquement 310, ou par des tranchées isolantes capacitives pouvant également servir de reprise de contact de substrat.

Comme décrit précédemment en relation avec la figure 2, les diodes D231-2 et D232-2 peuvent être formées par des diodes parasites d'un transistor de type MOS. Ces diodes peuvent donc être formées, par exemple, par une diode de substrat du type de la diode SD300. Selon un autre exemple, ces diodes peuvent être formées par une diode intrinsèque du type de la diode BD300, mais dans ce cas la borne de source du transistor à qui appartient la diode intrinsèque est reliée, de préférence connectée, à sa borne de substrat.

La figure 4 est une vue en coupe illustrant un exemple pratique de réalisation d'une diode D400.

La diode D400 est formée dans et sur un substrat 401 (N) dopée de type P. Un caisson 402 (N) dopé de type N, par exemple obtenu par un procédé d'épitaxie s'étend sur toute une portion supérieure du substrat 401. La jonction PN formée par le substrat 401 et le caisson 402 forme la diode D400. Plus particulièrement, la région d'anode de la diode D400 est formée par le substrat 401, et la région de cathode de la diode D400 est formée par le caisson 402.

Une reprise de contact peut être formée de la façon suivante. Une couche 403 (N) dopée de type N est formé sur la face supérieure de la couche 402, et une couche 404 (N+) dopée fortement de type N est formée sur une portion de la surface de la couche 403 pour former la reprise de contact. Selon un exemple, la couche 404 est reliée, de préférence connectée, à un noeud K400 formant la borne de cathode la diode D400. Le reste de la surface de la couche 403 est, par exemple, recouverte d'une couche 406 isolante électriquement.

Selon un exemple, la diode D400 est délimitée latéralement par une tranchée isolante électriquement 310 circulaire, ou par une tranchée isolante capacitive circulaire pouvant également servir de reprise de contact de substrat. Selon un exemple, la tranchée isolante 405 comprend un coeur isolant, ou un coeur en un matériau dopée fortement de type P, en contact avec le substrat 401, et, par exemple, un contour isolant électriquement.

Les détails des matériaux utilisés et des niveaux de dopages des structures présentées en relation avec les figures 3 et 4 ne sont pas décrits et sont à la portée de la personne du métier. De même, toutes les étapes d'un procédé de fabrication d'un tel transistor ou d'une telle diode sont à la portée de la personne du métier.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique de pilotage (Driv131, Driv132 ; Driv231, Driv232) d'un commutateur (130 ; 230) comprenant :
- une première borne (N110 ; N201) adaptée à recevoir un potentiel alternatif ;
- une deuxième borne (GND100 ; GND200) adaptée à recevoir un potentiel de référence ;
- un premier circuit de pilotage (Driv131 ; Driv231) dudit commutateur (130 ; 230) référencé à ladite première borne (N110 ; N201), formé sur un premier substrat, et comportant une première diode (D231-2) dont la région d'anode est reliée audit premier substrat ;
- un deuxième circuit de pilotage (Driv132 ; Driv232) référencé à ladite deuxième borne (GND100 ; GND200) formé sur un deuxième substrat différent du premier substrat, et comportant une deuxième diode (D232-2) dont la région d'anode est reliée audit deuxième substrat ;
dans lequel une région de cathode de ladite première diode (D231-2) est reliée audit deuxième circuit de pilotage (Driv132 ; Driv232), et une région de cathode de ladite deuxième diode (D232-2) est reliée audit premier circuit de pilotage (Driv131 ; Driv231).

2. Dispositif selon la revendication 1, dans lequel ledit premier circuit de pilotage (Driv131 ; Driv231) comprend un premier transistor (M231-1) de commande dudit commutateur (130 ; 230), et ladite région de cathode de ladite deuxième diode (D232-2) est reliée à une borne de drain dudit premier transistor (M231-1).

3. Dispositif selon la revendication 1 ou 2, dans lequel ledit deuxième circuit de pilotage (Driv132 ; Driv232) comprend un deuxième transistor (M232-1) de commande dudit commutateur (130 ; 230), et ladite région de cathode de ladite première diode (D231-2) est reliée à une borne de drain dudit deuxième transistor (M232-1).

4. Dispositif selon les revendications 2 et 3, dans lequel lesdits premier et deuxième transistors (M231-1, M232-1) sont des transistors de type MOS.

5. Dispositif selon l'une quelconque des revendications 1 à 4, dans lequel lesdites première et deuxième diodes (D231-2, D232-2) sont des diodes parasites de troisièmes transistors de type MOS.

6. Dispositif selon la revendication 5, dans lequel lesdites première et deuxième diodes (D231-2, D232-2) sont des diodes de substrat de troisièmes transistors.

7. Dispositif selon la revendication 5, dans lequel lesdites première et deuxième diodes (D231-2, D232-2) sont des diodes intrinsèque desdits troisièmes transistors dont les bornes de source sont reliées à leurs bornes de substrat.

8. Dispositif selon l'une quelconque des revendications 1 à 3, dans lequel lesdites première et deuxième diodes (D231-2, D232-2) sont des diodes isolées latéralement par des tranchées d'isolation profonde.

9. Dispositif selon l'une quelconque des revendications 1 à 8, dans lequel ledit premier circuit de pilotage (Driv231) comprend un circuit d'alimentation relié à ladite première borne (N110 ; N201).

10. Commutateur (130 ; 230) comprenant :
- un dispositif de pilotage (Driv131, Driv132 ; Driv231, Driv232) selon l'une quelconque des revendications 1 à 9 ;
- un premier thyristor (T131 ; T231) dont la cathode est reliée à ladite première borne (N110 ; N201), et dont l'anode est reliée à ladite deuxième borne (GND100 ; GND200) et adapté à être piloté par ledit premier circuit de pilotage (Driv131 ; Driv231) ; et
- un deuxième thyristor (T132 ; T232) dont l'anode est reliée à ladite première borne (N110 ; N201), et dont la cathode est reliée à ladite deuxième borne (GND100 ; GND200) et adapté à être piloté par ledit deuxième circuit de pilotage (Driv132 ; Driv232).

11. Commutateur selon la revendication 10 dans son rattachement à la revendication 2, dans lequel ledit premier transistor (M231-1) comprend une borne de source reliée à la gâchette dudit premier thyristor (T231).

12. Commutateur selon la revendication 10 ou 11 dans son rattachement à la revendication 3, dans lequel ledit deuxième transistor (M232-1) comprend une borne de source reliée à la gâchette dudit deuxième thyristor (T232).

13. Dispositif électronique (110) comprenant une charge (111 ; 210) adaptée à recevoir une tension alternative et un commutateur (130 ; 230) selon l'une quelconque des revendications 10 à 12, dans lequel une troisième borne de ladite charge (111 ; 210) est reliée à ladite première borne (N110 ; N201).

14. Système électronique (100 ; 200) comprenant un dispositif (110) selon la revendication 13 et une alimentation (120 ; 220) adaptée à fournir une tension alternative.

15. Procédé de commande d'une charge (111 ; 210) alimentée par une alimentation (120 ; 220) adaptée à fournir une tension alternative, dans lequel ladite charge (111 ; 210) est reliée à ladite alimentation (120 ; 220) par un commutateur (111 ; 230), ledit commutateur (130 ; 230) comprenant :
- une première borne (N110 ; N201) adaptée à recevoir un potentiel alternatif ;
- une deuxième borne (GND100 ; GND200) adaptée à recevoir un potentiel de référence ;
- un premier thyristor (T131 ; T231) dont la cathode est reliée à ladite première borne (N110 ; N201), et dont l'anode est reliée à ladite deuxième borne (GND100 ; GND200) ;
- un premier circuit de pilotage (Driv131 ; Driv231) dudit commutateur (130 ; 230) référencé à ladite première borne (N110 ; N201), formé sur un premier substrat, et comportant une première diode (D231-2) dont la région d'anode est reliée audit premier substrat ;
- un deuxième circuit de pilotage (Driv132 ; Driv232) dudit deuxième thyristor (T132 ; T232) référencé à ladite deuxième borne (GND100 ; GND200) formé sur un deuxième substrat différent du premier substrat, et comportant une deuxième diode (D232-2) dont la région d'anode est reliée audit deuxième substrat ;
dans lequel une région de cathode de ladite première diode (D231-2) est reliée audit deuxième circuit de pilotage (Driv132 ; Driv232), et une région de cathode de ladite deuxième diode (D232-2) est reliée audit premier circuit de pilotage (Driv131 ; Driv231).
